Europäisches Patentamt

European Patent Office

Office européen des brevets

(11) Veröffentlichungsnummer: **0 329 992**
**A2**

(12) EUROPÄISCHE PATENTANMELDUNG

(21) Anmeldenummer: **89101832.7**

(22) Anmeldetag: **02.02.89**

(51) Int. Cl.⁴: **H01L 29/743 , H01L 29/06 , H01L 29/10 , //H01L27/06**

(30) Priorität: **25.02.88 DE 3805999**

(43) Veröffentlichungstag der Anmeldung:
**30.08.89 Patentblatt 89/35**

(84) Benannte Vertragsstaaten:
**CH DE FR GB IT LI SE**

(71) Anmelder: **Siemens Aktiengesellschaft**
**Wittelsbacherplatz 2**
**D-8000 München 2(DE)**

(72) Erfinder: **Türkes, Peter, Dr. Dipl.-Phys.**
**Bussardstrasse 44**
**D-8025 Unterhaching(DE)**

(54) **Abschaltbarer Thyristor mit geringer Ansteuerleistung.**

(57) Thyristor mit einem oder mehreren Basisgebieten (4a) und in diese eingebetteten Emittergebieten (5a-5c), bei dem jedem Basisgebiet (4a) ein Feldeffekttransistor eines ersten Kanaltyps (T1) randseitig zugeordnet ist, der bei Zuführung eines Zündspannungsimpules (38) einer ersten Polarität an seine Gateelektrode (14) einen Zündstromkreis einschaltet, und bei dem den Emittergebieten (5c) jeweils Feldeffekttransistoren eines zweiten Kanaltyps (T2) zugeordnet sind, die bei Zuführung eines Löschspannungsimpulses (41) einer zweiten Polarität jeweils Emitter-Basis-Kurzschlüsse (42) wirksam schalten, die den Thyristor abschalten. Die Ansteuerung sämtlicher Feldeffekttransistoren (T1, T2) erfolgt über einen gemeinsamen Steuereingang (16).

EP 0 329 992 A2

## Abschaltbarer Thyristor mit geringer Ansteuerleistung

Die Erfindung bezieht sich auf einen Thyristor nach dem Oberbegriff des Patentanspruchs 1.

Ein Thyristor dieser Art ist aus der EP-A 0 179 230 bekannt. Er weist mehrere Basisgebiete mit jeweils eingefügten Emittergebieten auf, wobei wenigstens einem dieser Basisgebiete ein Feldeffekttransistor zugeordnet ist, der aus einem in das Basisgebiet eingefügten, entgegensetzt dotierten Sourcegebiet, aus einer Randzone des Basisgebiets, aus einer die Randzone überdeckenden und durch eine dünne elektrisch isolierende Schicht von dieser getrennten Gateelektrode und aus einem an die Randzone angrenzenden Teilgebiet der an das Basisgebiet angrenzenden Thyristorbasis besteht, wobei das Sourcegebiet mit einer elektrisch leitenden Belegung versehen ist, die auch das Basisgebiet kontaktiert. Dieser Thyristor wird durch Zuführung eines Zündspannungsimpulses an die Gateelektrode, d.h. ohne nennenswerte Ansteuerleistung, gezündet.

Der Erfindung liegt die Aufgabe zugrunde, einen Thyristor der eingangs genannten Art anzugeben, der nicht nur mit einer sehr kleinen Ansteuerleistung gezündet, sondern auch mit einer vergleichbar kleinen Ansteuerleistung abgeschaltet werden kann, wobei die Ansteuerung in beiden Fällen über ein und denselben Steuereingang erfolgen soll. Das wird erfindungsgemäß durch eine Ausbildung nach dem kennzeichnenden Teil des Patentanspruchs 1 erreicht.

Der mit der Erfindung erzielbare Vorteil liegt insbesondere darin, daß sowohl für das Zünden als auch für das Abschalten des Thyristors nur ein einziger Steuereingang benötigt wird, der lediglich mit Ansteuerleistungen beaufschlagt werden muß, die zur Umladung der Gateelektroden eines oder mehrerer Feldeffekttransistoren auf die Spannungswerte eines Zündspannungs impulses einer ersten Polarität bzw. eines Löschspannungsimpulses einer zweiten Polarität erforderlich sind. Der Patentanspruch 2 ist auf eine bevorzugte Weiterbildung der Erfindung gerichtet.

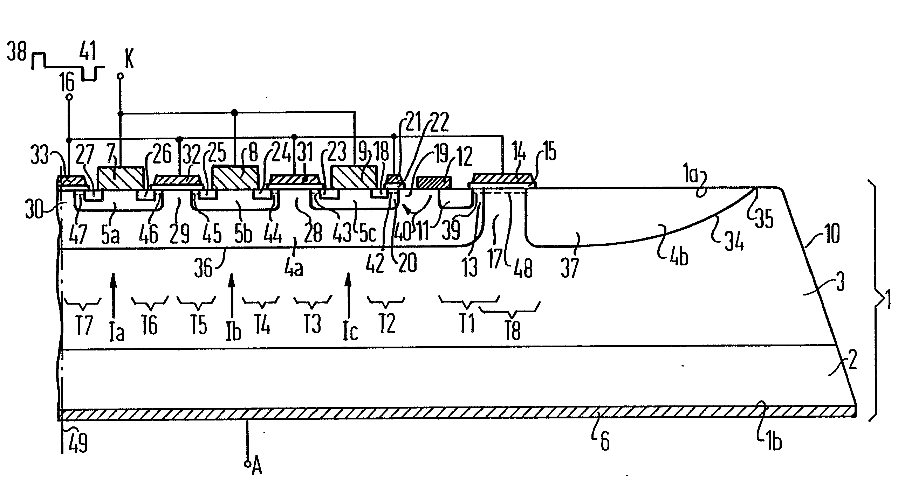

Die Erfindung wird nachfolgend anhand eines in der Zeichnung dargestellten, bevorzugten Ausführungsbeispiels näher erläutert.

Dabei wird von einem Thyristor mit einem scheibenförmigen Halbleiterkörper 1 aus dotiertem Halbleitermaterial, z.B. Silizium, ausgegangen. Er enthält eine Folge von Halbleiterschichten alternierender Leitfähigkeitstypen, die einen p-Emitter 2, eine n-Basis 3, eine p-Basis 4a, 4b und einen n-Emitter 5a, 5b und 5c darstellen. Der p-Emitter 2 ist dabei als eine zusammenhängende Schicht ausgebildet, die in einer Hauptfläche 1b von 1 mit einer an einen Anodenanschluß A gelegten anodenseitigen Elektrode 6 versehen ist. In der Hauptfläche 1b beträgt die Dotierungskonzentration des p-Emitters vorzugsweise etwa $10^{19}\,\mathrm{cm^{-3}}$. Die n-Basis 3, die aus einer weiteren zusammenhängenden Schicht mit einer Dotierungskonzentration von $5.10^{12}$ bis $10^{14}\,\mathrm{cm^{-3}}$ besteht, erstreckt sich bis zu einer Hauptfläche 1a von 1. Die p-Basis des Thyristors besteht aus einer Mehrzahl von p-Basisgebieten, z.B. 4a und 4b, die in die n-Basis 3 so eingefügt sind, daß sie jeweils von der Hauptfläche 1a des Halbleiterkörpers 1 ausgehen. Der n-Emitter besteht schließlich aus einer Mehrzahl von n-Emittergebieten, z.B. 5a, 5b und 5c, die in die p-Basisgebiete, z.B. 4a, so eingefügt sind, daß sie ebenfalls von der Hauptfläche 1a ausgehen. Die n-Emittergebiete, z.B. 5a, 5b und 5c, die an der Hauptfläche 1a etwa eine Dotierungskonzentration von $10^{20}\,\mathrm{cm^{-3}}$ aufweisen, sind in dieser Hauptfläche jeweils mit Teilen 7, 8 und 9 einer kathodenseitigen Elektrode versehen, die mit einem Kathodenanschluß K verbunden sind. Die Dotierungskonzentration der p-Basisgebiete, z.B. 4a, beträgt dort, wo sie an die eingefügten n-Emittergebiete, z.B. 5a, angrenzen, z.B. $10^{17}\,\mathrm{cm^{-3}}$.

Auch in dem sich nach links anschließenden, nicht dargestellten Teil des Halbleiterkörpers 1 sind weitere n-Emittergebiete vorgesehen, wobei letztere wieder von Teilen der kathodenseitigen Elektrode kontaktiert werden, die mit K verbunden sind. Der abgeschrägte Rand des Thyristors ist mit 10 bezeichnet. Die weiteren n-Emittergebiete können in dem nach links entsprechend verlängerten p-Basisgebiet 4a oder in einem oder mehreren p-Basisgebieten, die neben dem Gebiet 4a in die n-Basis 3 eingefügt sind, vorgesehen sein.

In das p-Basisgebiet 4a ist das n-leitende Sourcegebiet 11 eines n-Kanal-Feldeffekttransistors T1 eingefügt, das sich bis zur Hauptfläche 1a erstreckt und in dieser mit einer leitenden Belegung 12 versehen ist, die in Richtung auf das n-Emittergebiet 5c soweit verlängert ist, daß sie die laterale Begrenzung von 11 überragt und das p-Basisgebiet 4a kontaktiert. Eine Randzone 13 des p-Basisgebiets 4a, die sich bis an die Hauptfläche 1a und bis an den rechten Rand des Sourcegebietes 11 erstreckt, wird von einer Gateelektrode 14 überdeckt, die durch eine dünne elektrisch isolierende Schicht 15 von der Hauptfläche 1a getrennt ist und mit einem Steuereingang 16 verbunden ist. Der an die Randzone 13 rechtsseitig angrenzende Teilbereich 17 der n-Basis 3 bildet das Draingebiet von T1.

Am linksseitigen, in der Zeichnung nicht dargestellten Rand des p-Basisgebiets 4a kann ein anderer, entsprechend T1 ausgebildeter n-Kanal-Feldeffekttransistor vorgesehen sein. Wenn weitere p-Basisgebiete, die entsprechend dem Gebiet 4a ausgebildet sind, in die n-Basis 3 des Thyristors eingefügt sind, können an den Rändern derselben weitere n-Kanal-Feldeffekttransistoren angeordnet sein, die jeweils entsprechend T1 ausgebildet sind.

In das p-Basisgebiet 4a ist ein p-Kanal-Feldeffekttransistor T2 eingefügt, dessen Draingebiet aus einer in das n-Emittergebiet 5c eingefügten, p-leitenden Halbleiterzone 18 besteht. Sein Sourcegebiet wird von einem an den rechten Rand des n-Emittergebiets 5c angrenzenden Teilgebiet 19 des p-Basisgebiets 4a gebildet, während sein Kanalbereich aus dem zwischen den Gebieten 18 und 19 liegenden Randbereich 20 des n-Emittergebiets 5c besteht. Der Randbereich 20 wird von einer Gateelektrode 21 überdeckt, die durch eine dünne elektrisch isolierende Schicht 22 von der Hauptfläche 1a des Halbleiterkörpers 1 getrennt ist. Das Sourcegebiet 18 wird von dem Teil 9 der kathodenseitigen Elektrode kontaktiert. Die Gateelektrode 21 ist dabei mit dem Steuereingang 16 verbunden.

Weitere, in die n-Emittergebiete 5c, 5b und 5a eingefügte p-leitende Gebiete 23 bis 27 bilden die Draingebiete von p-Kanal-Feldeffekttransistoren T3 bis T7, die entsprechend T2 ausgebildet sind. Die Sourcegebiete von T3 und T4 werden durch das Teilgebiet 28 von 4a dargestellt. Die Sourcegebiete von T5 und T6 durch das Teilgebiet 29 von 4a. Das Sourcegebiet von T7 besteht aus dem Teilgebiet 30 des p-Basisgebiets 4a. Die Kanalbereiche der Transistoren T3 bis T7, die aus den jeweils zwischen den Source- und Draingebieten liegenden Randbereichen der n-Emittergebiete 5c, 5b und 5a bestehen, sind durch Gateelektroden überdeckt, die jeweils mit dem Steuereingang 16 verbunden sind. Dabei bestehen die Gateelektroden von T3 und T4 aus Teilen einer gemeinsamen Gateelektrode 31 und die Gateelektroden von T5 und T6 aus Teilen einer gemeinsamen Gateelektrode 32. Die Gateelektrode von T7 ist mit 33 bezeichnet. Entsprechend der Gateelektrode 21 sind auch die Gateelektroden 31 bis 33 durch dünne, elektrisch isolierende Schichten von der Hauptfläche 1a getrennt und mit dem Steuereingang 16 verbunden. Das Sourcegebiet 23 wird vom Teil 9 der kathodenseitigen Elektrode kontaktiert, die Sourcegebiete 24 und 25 vom Teil 8 und die Sourcegebiete 26 und 27 vom Teil 7 derselben.

Mit 4b ist ein lateral neben dem p-Basisgebiet 4a angeordnetes p-Basis-Randabschlußgebiet bezeichnet, das von der n-Basis 3 durch einen planaren pn-Übergang 34 getrennt ist. Dieser nähert sich in Richtung auf den Thyristorrand 10 ganz allmählich der die n-Emittergebiete enthaltenden Hauptfläche 1a an und erreicht sie bei 35. Durch die allmähliche Annäherung des pn-Übergangs 34 an die Hauptfläche 1a wird erreicht, daß Blockierspannungen, die den Anodenanschluß auf ein positiveres Potential legen als den Kathodenanschluß K und den pn-Übergang 34 in Sperrrichtung vorspannen, erst beim Erreichen eines sehr hohen Spannungswertes zum Durchbruch des pn-Übergangs 34 bzw. des die Teile 3 und 4a trennenden pn-Übergangs 36 führen. Der Wert dieser Durchbruchspannung entspricht dabei etwa dem Spannungswert, bei dem der parallel zur Hauptfläche 1a verlaufende Teil des pn-Übergangs 36 durchbricht. Der laterale Abstand der Gebiete 4a und 4b wird durch die Breite des Teilbereichs 17 der n-Basis 3 bestimmt.

Die die Randzone 13 überdeckende Gateelektrode 14 ist nach einer bevorzugten Weiterbildung der Erfindung soweit in Richtung auf das p-Basis-Randabschlußgebiet 4b verlängert, daß sie den gesamten zwischen den Gebieten 4a und 4b liegenden Teilbereich 17 der n-Basis 3 überdeckt. Dabei ist die elektrisch isolierende Schicht 15 entsprechend verlängert, so daß auch die verlängerte Gateelektrode 14 gegen die Grenzfläche 1a elektrisch isoliert ist. Hierdurch wird ein weiterer p-Kanal-Feldeffekttransistor T8 gebildet, der die p-leitende Randzone 13 und die linksseitige Randzone 37 von 4b als Source- bzw. Draingebiet enthält und den n-leitenden Teilbereich 17 der n-Basis 3 als Kanalgebiet aufweist, das von der verlängerten Gateelektrode 14 isoliert überdeckt wird. Die Ansteuerung von T8 erfolgt über den mit 14 verbundenen Steuereingang 16.

Im blockierenden Zustand des Thyristors liegt z.B. eine Spannung von 1000 Volt zwischen den Anschlüssen A und K, wobei der Anschluß A ein positiveres Potential aufweist als K. Legt man nun einen positiven Zündspannungsimpuls 38 bei 16 an, so bildet sich in der Randzone 13 unterhalb der Gateelektrode 14 eine Inversionsschicht 39 aus, die einen leitenden Kanal zwischen dem Sourcegebiet 11 und dem Draingebiet 17 darstellt. Über den Kanal 39 fließt dann ein Zündstrom. Dieser besteht aus einem Elektronenstrom vom Sourcegebiet 11 durch den Kanal 39 in Richtung zum p-Emitter 2, der dort eine Löcherinjektion bewirkt. Gleichzeitig fließt ein Löcherstrom (Pfeil 40) vom Sourcegebiet 11 über die leitende Verbindung 12 in das p-Basisgebiet 4a und steuert dort den pn-Übergang nach 5c an. Elektronen- und Löcherstrom sind dem Betrag nach gleich groß und können zusammen als ein der Anodenseite entnommener Zündstrom bezeichnet werden. Als Folge des Löcherstroms injiziert das n-Emittergebiet 5c negative Ladungsträger in das p-Basisgebiet 4a, die in Richtung auf den p-Emitter 2 transportiert werden und am pn-Übergang zwischen den Teilen 2 und 3 eine Injektion von positiven Ladungsträgern in die n-Basis 3 bewirken. Damit zündet der Thyristor zunächst im Bereich des n-Emittergebiets 5c. Da die p-Kanal-Transistoren T2 bis T7 bei positiver Spannung am Steuereingang 16 sperren, wird auch der übrige Teil des Thyristorquerschnitts rasch gezündet, so daß zwischen der Elektrode 6 und den n-Emittergebieten 5a, 5b und 5c jeweils Laststromanteile $I_a$, $I_b$ und $I_c$ fließen, die sich mit entsprechenden Laststromanteilen in den Bereichen von weiteren n-Emittergebieten zum Laststrom des Thyristors zusammensetzen. Während des Zündvorgangs und im laststromführenden Zustand des Thyristors liegen keine negativen Spannungen am Steuereingang 16, so daß in diesen Betriebszuständen sowohl die Transistoren T2 bis T7 als auch der p-Kanal-Feldeffekttransistor T8 gesperrt sind.

Zum Abschalten des Thyristors wird dem Steuereingang 16 ein negativer Löschspannungsimpuls 41 zugeführt. Dieser bewirkt die Bildung einer Inversionsschicht 42 im Randbereich 20 des n-Emittergebiets 5c unterhalb der Gateelektrode 21. Die Inversionsschicht stellt einen die Gebiete 18 und 19 niederohmig miteinander verbindenden, leitenden Kanal dar. Damit gelangt T2 in den leitenden Zustand. Analog hierzu werden die Transistoren T3 bis T7 durch die Bildung von Inversionsschichten 43 bis 47 leitend geschaltet. Im leitenden Zustand der p-Kanal-Feldeffekttransistoren, z.B. von T2 bis T7, sind die Sourcegebiete, z.B. 18 und 23 bis 27, und damit die mit diesen verbundenen Teile der kathodenseitigen Elektrode, z.B. 7 bis 9, mit den p-Basisgebieten, z.B. 4a, niederohmig verbunden, so daß die pn-Übergänge zwischen den n-Emittergebieten, z.B. 5a bis 5c, und den p-Basisgebieten, z.B. 4a, praktisch kurzgeschlossen sind. Hierdurch werden die aus dem p-Emitter 2 in die n- Basis 3 injizierten positiven Ladungsträger, die ohne diese Kurzschlüsse zu den zuletzt genannten pn-Übergängen transportiert werden würden, im wesentlichen über die genannten Kurzschlüsse in die n-Emittergebiete 5a bis 5c transportiert, ohne daß sie an diesen pn-Übergängen weitere Injektionsvorgänge auslösen können. Damit werden aber die Laststromanteile $I_a$ bis $I_c$ und die in den Bereichen weiterer n-Emittergebiete auftretenden, weiteren Laststromanteile abgeschaltet, so daß der Thyristor gelöscht wird.

Zum Zünden des Thyristors genügt es, die Kapazitäten der Gateelektrode 14 und weiterer dieser gegebenenfalls parallel geschalteter Gateelektroden gegenüber dem Halbleiterkörper auf den Spannungswert des Zündspannungsimpulses 38 aufzuladen, während es zum Löschen ausreicht, die Kapazitäten der Gateelektroden 21 und 31 bis 33 sowie weiterer, diesen gegebenenfalls parallel geschalteter Gateelektroden auf den Spannungswert des Löschspannungsimpulses 41 aufzuladen. Beides kann ohne nennenswerten Leistungsverbrauch geschehen.

Bei der genannten Weiterbildung der Erfindung mit dem das p-Basisgebiet 4a und das p-Basis-Randabschlußgebiet 4b verbindenden p-Kanal-Feldeffekttransistor T8 bewirkt der negative Löschspannungsimpuls 41 die Bildung einer Inversionsschicht 48 im Teilbereich 17 der n-Basis 3 unterhalb der Gateelektrode 14. Die Inversionsschicht 48 verhindert, daß sich die beim Abschalten des Thyristors infolge einer bei A und K anliegenden Blockierspannung am pn-Übergang 36 ausbildende Raumladungszone mit ihrem im Teilbereich 17 liegenden Rand bis zur Hauptfläche 1a durchgreift. Dabei wird die Hauptfläche 1a durch die Inversionsschicht 48 gegen die durch die Blockierspannung gegebene relativ hohe Spannung, die an diesem Rand der Raumladungszone auftritt, abgeschirmt. Hat sich dann im weiteren Verlauf des Abschaltvorgangs eine genügend hohe Sperrspannung am pn-Übergang 36 aufgebaut, so greift der in der n-Basis liegende Rand der Raumladungszone am pn-Übergang 36 zu dem den Teilbereich 17 begrenzenden Teil des pn-Übergangs 34 durch, so daß 4b als ein innerer Feldring der p-Basis des Thyristors betrachtet werden kann. Durch die Funktion des Transistors T8 wird somit ein Durchbruch am pn-Übergang 36 während des Abschaltvorgangs trotz des Anliegens einer hohen Blockierspannung verhindert.

Nach einer ersten Ausgestaltung der dargestellten Ausführungsform sind die Gebiete 4a, 4b, 5a bis 5c und 11 sowie die Teile 7 bis 9, 14, 21 und 31 bis 33 streifenförmig ausgebildet, wobei ihre Abmessungen in einer etwa senkrecht zur Bildebene verlaufenden Richtung größer sind als in der Bildebene. Andererseits kann die Querschnittsdarstellung beispielsweise auch so aufgefaßt werden, daß es sich um einen rotationssymmetrischen Halbleiterkörper mit einer Symmetrieachse 49 handelt. Dabei sind die Gebiete 4a und 4b sowie die Gebiete 5a bis 5c und 11 kreisringförmig ausgebildet. Entsprechendes gilt dann auch für die dargestellten Elektroden und die leitenden Belegungen, die ebenfalls kreisringförmig ausgebildet sind.

Neben den bisher beschriebenen Ausführungsformen gehören auch solche zur Erfindung, bei denen die genannten Halbleitergebiete jeweils durch solche des entgegengesetzten Leitfähigkeitstyps ersetzt sind, wobei anstelle der genannten Spannungen und Ströme solche des entgegengesetzten Vorzeichens verwendet werden. In diesen Fällen sind auch die Bezeichnungen der Anschlüsse A und K miteinander zu vertauschen.

## Ansprüche

1. Thyristor mit einer Folge von Halbleiterschichten alternierender Leitfähigkeitstypen, die einen mit einer anodenseitigen Elektrode (6) versehenen p-Emitter (2), eine n-Basis (3), eine p-Basis

(4a, 4b) und einen mit einer kathodenseitigen Elektrode (7, 8, 9) versehenen n-Emitter (5a, 5b, 5c) darstellen, bei dem einer der Emitter aus einem oder mehreren Emittergebieten (5a, 5b, 5c) besteht, bei dem die an diesen Emitter angrenzende Basis aus einem oder mehreren Basisgebieten (4a) besteht, die jeweils ein oder mehrere Emittergebiete (5a, 5b, 5c) enthalten, und bei dem wenigstens einem der Basisgebiete (4a) zumindest ein erster Feldeffekttransistor (T1) zugeordnet ist, der aus einem in das Basisgebiet (4a) eingefügten und zu diesem entgegengesetzt dotierten Sourcegebiet (11), einer Randzone (13) des Basisgebiets (4a), einer die Randzone (13) überdeckenden, durch eine dünne elektrisch isolierende Schicht (15) von dieser getrennten ersten Gateelektrode (14) und einem an die Randzone (I3) angrenzenden Teilbereich (17) der an das Basisgebiet (4a) angrenzenden Basis (3) als Draingebiet besteht, wobei das Sourcegebiet (11) mit einer ersten elektrisch leitenden Belegung (12) versehen ist, die auch das Basisgebiet (4a) kontaktiert, **dadurch gekennzeichnet,** daß in wenigstens ein Basisgebiet (4a), welches ein oder mehrere Emittergebiete (5a-5c) enthält, zweite Feldeffekttransistoren (T2-T7) eingefügt sind, von denen jeder aus einem in ein Emittergebiet (5c) eingefügten, zu diesem entgegengesetzt dotierten Draingebiet (18) aus einem an dieses Emittergebiete (5c) angrenzenden Teilgebiet (19) des Basisgebiets (4a) als Sourcegebiet und aus einem zwischen diesem Draingebiet (18) und Sourcegebiet (19) liegenden Randbereich (20) dieses Emittergebiets (5c) besteht, daß der Randbereich (20) des Emittergebiets (5c) von einer zweiten, gegen ihn elektrisch isolierten Gateelektrode (21) überdeckt wird, und daß alle ersten und zweiten Gateelektroden (14, 21) mit einem gemeinsamen Steuereingang (16) verbunden sind.

2. Thyristor nach Anspruch 1, **dadurch gekennzeichnet,** daß lateral neben einem oder mehreren Basisgebieten (4a) ein den gleichen Leitfähigkeitstyp wie diese aufweisendes Basis-Randabschlußgebiet (4b) in die angrenzende Basis (3) eingefügt ist, das von der angrenzenden Basis (3) durch einen pn-Übergang (34) getrennt ist, der sich in Richtung auf den Thyristorrand (10) allmählich der die Emittergebiete (5a-5c) enthaltenden Hauptfläche (1a) des Thyristors annähert, und daß eine oder mehrere die Randzonen (13) eines oder mehrerer Basisgebiete (4a) überdeckende, erste Gateelektroden (14) in Richtung auf das Basis-Randabschlußgebiet (4b) soweit verlängert sind, daß sie die zwischen den zuletzt genannten Randzonen (I3) und dem Basis-Randabschlußgebiet (4b) liegenden Teilbereiche (17) der angrenzenden Basis (3) überdecken, wobei die insoweit verlängerten ersten Gateelektroden (14) gegen diese Teilbereiche (17) elektrisch isoliert sind.